# EUROPÄISCHE PATENTSCHRIFT

(11) **EP 2 577 763 B1**
(45) Veröffentlichungstag und Bekanntmachung des Hinweises auf die Patenterteilung: **17.01.2018**
(21) Anmeldenummer: 11723012.8
(22) Anmeldetag: 05.05.2011
(51) Int. Cl.: H01L 51/00

(54) **STRUKTURIERTE BESCHICHTUNG**
STRUCTURED COATING
REVÊTEMENT STRUCTURÉ

(30) Priorität: 26.05.2010 DE 102010029317
(43) Veröffentlichungstag der Anmeldung: 10.04.2013
(73) Patentinhaber: Universität zu Köln, 50923 Köln (DE)
(72) Erfinder: KLESPER, Heike, 51467 Bergisch Gladbach (DE); MEERHOLZ, Klaus, 51503 Rösrath (DE); SCHNEIDER, Stefan, 97437 Hassfurt (DE)
(74) Vertreter: Gille Hrabal
(86) Internationale Anmeldenummer: PCT/EP2011/057213
(87) Internationale Veröffentlichungsnummer: WO 2011/147666

(56) Entgegenhaltungen:
- EP-A2- 1 128 449
- JP-A- 2007 305 507
- US-A1- 2007 202 258
- US-B1- 6 350 609

## Beschreibung

Die Erfindung betrifft ein Verfahren zur selektiven Beschichtung strukturierter oder mikrostrukturierter leitfähiger Strukturen mittels Elektrospray. Als Elektrospray wird ein Verfahren zur Zerstäubung von Flüssigkeiten mit Hilfe eines elektrischen Feldes bezeichnet. Im vorliegenden Fall enthält eine solche zerstäubte Flüssigkeit Material, mit dem eine anziehend gepolte Elektrode beschichtet werden soll. Aus der Druckschrift DE10344135A1 geht eine Elektrospraybeschichtung hervor, um Funktionsschichten auf elektrisch nicht leitfähigen Oberflächen aufzubringen.

Unter atmosphärischen Bedingungen (z. B. in Umgebungsluft) werden in der Regel leitfähige Flüssigkeiten zerstäubt. Anwendungsbeispiele sind hier z. B. elektrostatische Oberflächenbeschichtungen (Lackierung, Korrosionsschutz, medizinische Inhalationsaerosole) oder analytische Geräte (Massenspektrometer).

In der Druckschrift EP 0 258 016 wird ein Elektrospray-Beschichtungsverfahren beschrieben, bei dem eine Beschichtungslösung über eine Vielzahl von flächig verteilt angeordneten Hohlnadeln zerstäubt wird. Mit Hilfe eines elektrischen Potenzials wird die zerstäubte Beschichtungslösung auf ein Substrat gelenkt und darauf als dünner Film abgeschieden.

Aus der Druckschrift JP 2007305507 A ist eine Abscheidung von Beschichtungsmaterial mittels Elektrospray auf einem elektrisch leitfähigen Substrat bekannt. Das elektrisch leitfähige Substrat umfasst ein elektrisch leitfähiges Muster, auf dem abgeschieden wird. Bei einem solchen Verfahren wird besonders viel Material an Randbereichen der Muster abgeschieden. Es entstehen daher Strukturen mit erhöhten Randbereichen, die bei einem späteren Bauteil Feldstärkeinhomogenitäten hervorrufen können. Dies kann die Funktionsweise eines Bauteils verschlechtern sowie die Haltbarkeit beeinträchtigen.

Die Druckschrift DE 10 2005 038 956 B3 offenbart ein Verfahren zum Beschichten einer Struktur, die einen Halbleiterchip aufweist. Dabei wird ein elektrostatisches Abscheiden von Beschichtungspartikeln auf den zu beschichtenden Flächen der Struktur angewandt.

Der Druckschrift JP 04333826 A ist ein elektrostatisches Beschichtungsverfahren zu entnehmen, bei dem die Dichte des abzuscheidenden Materials elektrostatisch gesteuert wird.

Aus der Druckschrift "R. Saf et al., Thin organic films by atmospheric-pressure ion deposition, Nature Materials 2004, 3 (5), 323-329" ist bekannt, einen Materialstrahl mittels Elektrospray und elektrostatischen Linsen zu lenken, um das Material gesteuert auf einem Substrat abzuscheiden. Es handelt sich dabei um ein schreibendes Verfahren, bei dem Material seriell und damit relativ langsam abgeschieden wird.

Aus der Druckschrift "Park et al., High-resolution electrohydrodynamic jet printing, Nature Materials 2007, 6 (10), 782-789" ist bekannt, kleine Strukturen auf einem Substrat abzuscheiden.

In der Druckschrift "D.J. Vak, S.S. Kim, J. Jo, S.H. Oh, S.I. Na, J.W. Kim, D.Y. Kim, Fabrication of organic bulk heterojunction solar cells by a spray deposition method for low-cost power generation, Applied Physics Letters 2007, 91 (8), 081102" wird eine pneumatische Zerstäubung zur Herstellung von organischen Solarzellen beschrieben.

Aus der Druckschrift WO 2009/043815 ist bekannt, mittels eines Elektrosprayverfahrens Materialien abzuscheiden, um so zu einer leistungsfähigen OLED zu gelangen.

Beschichtungsverfahren unter Einsatz einer Maske sind aus den Druckschriften EP 1 128 449 A2, US 6,350,609 B1, JP 2007 305507 A sowie US 2007/0202258 A1 bekannt.

Aus dem Stand der Technik darüber hinaus bekannte Verfahren zur strukturierten Aufbringung von Materialien für die organische Elektronik beruhen auf thermischer Sublimation (kleine intakt sublimierbare Moleküle), oder auf Aufschleuderverfahren (lösliche Materialien, auch Polymere).

Bei der thermischen Sublimation werden Materialien in einem Hochvakuumprozess flächig im Bereich des Sublimationskegels aufgebracht. Eine strukturierte Abscheidung kann erfolgen, wenn eine Maske die Bereiche abdeckt, die nicht beschichtet werden sollen.

Erfolgt eine Strukturierung mittels Vakuumsublimation organischer Materialien durch eine Maske hindurch, so muss für jeden Material- und/oder Schichtdickenwechsel ein Maskentausch im Hochvakuum durchgeführt werden. Je kleiner die Strukturen sind, um so filigraner muss eine Maske beschaffen sein. Je filigraner eine Maske ist, um so eher wird eine Maske zugesetzt.

Beim Aufschleuderverfahren wird eine Lösung des aufzubringenden Materials auf ein schnell rotierendes Substrat aufgebracht. Die Lösung wird durch die Zentrifugalkräfte zur Seite weggeschleudert und es bleibt nur eine dünne, gleichmäßige Schicht übrig. Anschließend wird diese dünne unstrukturierte Schicht lithographisch strukturiert (Belichtung durch Maske und anschließende Entwicklung der Struktur).

Ein lithographisches Verfahren erfordert eine relativ aufwändige Maskentechnik mit Ausrichtungs-, Belichtungs- und Entwicklungsschritten.

Beim Druckverfahren z.B. über Inkjet werden kleine Tropfen des aufzubringenden Materials auf das Substrat gebracht. Das Inkjet-Druckverfahren ist ein "schreibendes" Verfahren, das ein Substrat nur zeilenweise beschichten kann. Das zu beschichtende Substrat muss vor dem Bedrucken mit gut- und schlecht-benetzenden Strukturen versehen werden, damit die auftreffenden Tropfen nicht über die zu beschichtenden Bereiche hinaus treten können. Da nur zeilenweise beschichtet wird, ist es relativ zeitaufwendig, mit einem Druckverfahren große Flächen zu beschichten.

Die Aufgabe der Erfindung besteht in der Schaffung eines weiter entwickelten Verfahrens, mit dem strukturiert beschichtet werden kann. Die Aufgabe der Erfindung wird durch ein Verfahren mit den Merkmalen des Patentanspruchs 1 gelöst.

Zur Lösung der Aufgabe wird eine Elektrospraybeschichtung durchgeführt, wobei das Substrat, auf dem abgeschieden wird, leitfähige Strukturen aufweist, die während der Abscheidung anziehend auf die mit Hilfe eines elektrischen Feldes zerstäubte Flüssigkeit wirken. Hierdurch wird das in der zerstäubten Flüssigkeit befindliche aufgeladene Material zu den leitfähigen Strukturen gelenkt und auf diesen oder oberhalb dieser Strukturen abgeschieden.

Erfindungsgemäß gibt es nicht lediglich anziehende Strukturen, auf denen abgeschieden werden soll, sondern auch damit korrespondierende, benachbarte Strukturen, die, mit Hilfe des an Ihnen anliegenden Potenzials, eine dreidimensionale Gestaltung des abgeschiedenen Materials ermöglichen. Diese Strukturen sind oberhalb des Substrats in Form einer Maske vorgesehen. Diese Strukturen können aus einem leitfähigen Material bestehen, an das ein geeignetes elektrisches Potenzial angelegt wird.

Es können mithilfe der benachbarten Strukturen unerwünschte Überhöhungen am Rand vermieden werden, wie sie automatisch entstehen, wenn eine leitfähige Struktur, welche sich auf einer nicht-leitfähigen Unterlage befindet, mit aufgeladenem Material beschichtet wird. Aufgrund der benachbarten Strukturen können auf kleiner Größenskala (insbesondere < 5 mm breit, <1 cm hoch, Länge beliebig, typischerweise aber eher zwischen 0,1-500 µm breit, <100 µm hoch, Länge beliebig) dreidimensionale Strukturen aufgebracht werden. So können zum Beispiel Halbkugeln, Stufenpyramiden, photonische Kristalle oder Kegel abgeschieden werden. Längliche Strukturen können zum Beispiel in Form von Halbsäulen oder Dreieckssäulen oder Treppensäulen abgeschieden worden sein. Ebene Oberflächen ohne Überhöhung an den Randbereichen können erhalten werden, also zum Beispiel dünne Materialstreifen ohne Kantenüberhöhungen.

Es wird flächig abgeschieden, also zum Beispiel zeitgleich auf unterschiedlichen Strukturen, wobei jede Struktur von Anfang an vollflächig beschichtet wird. Die vorliegende Erfindung zielt also nicht auf die Erzeugung eines Schreibstrahls ab, sondern im Gegenteil auf die Herstellung räumlich ausgedehnter Strukturen und/ oder auf die Herstellung einer Vielzahl kleiner Strukturen. Eine Vielzahl kleiner Strukturen können eine Vielzahl sehr kleiner Linsen oder Halbkugeln, eine Vielzahl von dünnen Materialstegen oder Gitter sein. Kleine Strukturen im Sinne der Erfindung weisen Strukturhöhen von einigen mm bis hinab zu ca. 10 nm auf. Sollen besonders ausgedehnte Flächen mit solch kleinen Strukturen versehen werden, können statt einer einzelnen Sprayquelle auch mehrere nebeneinander positionierte Sprayquellen gleichzeitig verwendet werden.

Erfindungsgemäß hergestellte Strukturen werden zum Beispiel als optische Lichtein- und auskoppelstrukturen, Beugungs- und/ oder Reflexionsgitter oder filigrane leuchtende Strukturen verwendet.

Auch bei großen Flächen in Leuchtdioden oder Solarzellen (5cmx5cm, 10cmx10cm, 50cm x50cm, oder größer) sind Überhöhungen an den Kanten schädlich, da sie zu einer reduzierten Performance und Lebensdauer der Bauteile führen. Mit Hilfe der Erfindung können auch derart ausgedehnte Flächen so beschichtet werden, dass überhöhte Randbereiche vermieden werden. Dies gilt in gleicher Weise für sehr schmale Strukturen mit einer Breite von 250 µm und weniger. Auch hier können zur Beschichtung ausgedehnter Flächen statt einer einzelnen Sprayquelle auch mehrere nebeneinander positionierte Sprayquellen gleichzeitig verwendet werden

Das Spray wird also zum Beispiel in einer Ausführungsform vor seinem Auftreffen auf leitfähige, anziehend gepolte Strukturen durch eine Maske hindurch geleitet, die mit den anziehend gepolten Strukturen korrespondierende Durchlässe aufweist. Die Maske ist so gestaltet bzw. kann auf ein solches elektrisches Potenzial gebracht werden, dass die Maske während des Abscheidens in Bezug auf das Spray abstoßend oder anziehend zu wirken vermag. Insbesondere im Vergleich zu dem aus der JP 2007305507 A bekannten Stand der Technik kann so das Abscheidungsverhalten auf den anziehend wirkenden Strukturen verbessert gesteuert werden.

Ergänzend können auch auf dem Substrat benachbart aufgebrachte leitfähige Strukturen benutzt werden, um mithilfe eines angelegten Potenzials eine Abscheidung geometrisch zu steuern. Gerade im Vergleich zu dem aus der JP 2007305507 A bekannten Stand der Technik können auf diese Weise Bauteile mit verbesserten Eigenschaften erhalten werden.

Werden wie im aus JP 2007305507 A bekannten Stand der Technik leitfähige Strukturen auf einer nicht-leitfähigen Unterlage aus einer geladenen Spraywolke beschichtet, laden sich die nicht-leitfähigen Bereiche durch erste auftreffende geladene Bestandteile aus der Spraywolke so auf, dass sie abstoßend zur Spraywolke wirken und Material auf die leitfähige benachbarte Struktur und besonders auf deren Randbereich umgelenkt wird. Dadurch entsteht bei der Beschichtung eine ungewollte Überhöhung der Randbereiche. Damit ebene Flächen ohne überhöhte Ränder deponiert werden, oder auch um die Randbereiche der deponierten Strukturen dreidimensional formen zu können, wirken erfindungsgemäß in enger Nachbarschaft zu den zu beschichtenden Strukturen Potenziale, die ungewünschte Effekte der nicht-leitfähigen Unterlage kompensieren und die zusätzlich auf die laterale Materialdeposition auf der zu beschichtenden Struktur Einfluss nehmen.

Mit Hilfe einer abstoßend gepolten Maske können selbst sehr filigrane Strukturen erzeugt werden, ohne dass sich die Maske zusetzen könnte, da die physisch vorhandenen Durchgänge in der Maske relativ groß bzw. breit im Vergleich zur Größe und Breite der Schichten sein können, die auf einer
anziehend gepolten Elektrode abgeschieden werden sollen. Erst durch Anlegen eines abstoßend wirkenden Potenzials wird der für das Spray zur Verfügung stehende Durchgang durch die Maske hindurch elektrostatisch verkleinert, um auf einem Substrat in gewünschter Weise zwecks Materialabscheidung aufzutreffen. Bei einer Verwendung einer Maske als Potenzial gebendes Mittel (statt auf dem Substrat benachbart aufgebrachter Strukturen) ist also die genaue Größe der Maskenöffnung unkritisch. Der genaue zu beschichtende Bereich ist durch die anziehend gepolte zu beschichtende Struktur vorgegeben.

Eine Maske besteht zweckmäßig aus einem vorzugsweise möglichst dünnen Metallblech aus zum Beispiel Messing, Edelstahl, Nickel, Aluminium. Eine Maske ist vorzugsweise nicht dicker als 0,5 mm und weist zum Beispiel eine Dicke von 0,3 mm, 0,2 mm oder 0,08 mm auf.

Zwar ist aus dem Stand der Technik bekannt, bei der Elektrospraybeschichtung eine Maske über der zu beschichtenden Fläche zu verwenden. Morozov et al beschreiben in US Patent Nr. 6,787,313 B2 eine über der zu beschichtenden Probe angeordnete Maske aus dielektrischem Material, die dazu dient, nur an den von der Maske nicht-bedeckten Stellen Material abzuscheiden. Diese Maske dient ausschließlich der lateral strukturierten Abscheidung. Sie lädt sich durch zufällig auftreffende Tropfen abstoßend zum Spray auf und besitzt damit einen abstoßenden Effekt auf die Spraywolke, die dadurch eingeschnürt wird. Das abstoßende Potenzial an der dielektrischen Maske stellt sich aber willkürlich ein und kann nicht angepasst oder variiert werden. Durch diese Anordnung wird besonders viel Material auf den Randbereich der zu beschichtenden Struktur umgelenkt, wodurch bei der Beschichtung eine ungewollte Überhöhung der Randbereiche entsteht. Im Gegensatz dazu besteht bei der vorliegenden Erfindung die Maske aus leitfähigem Material, das gezielt auf ein gewünschtes Potenzial gelegt werden kann bzw. dessen Potenzial im Verlauf der Beschichtung nach Wunsch variiert werden kann. Diese Maske dient dazu, mit Hilfe von einstellbaren und variablen Potenzialen die Seitenkanten des abgeschiedenen Materials dreidimensional nach Wunsch zu formen. Die lateral strukturierte Abscheidung erfolgt in der vorliegenden Erfindung nicht durch eine Maske, sondern durch die bereits vorstrukturierten leitfähigen Strukturen auf denen abgeschieden wird. Es ist bislang kein Verfahren bekannt, mit dem man während des Beschichtungsprozesses durch den Einfluss unmittelbar benachbarter Potenziale gezielt Einfluss auf die Form der abgeschiedenen Materialschicht nimmt.

Zwar ist aus dem Stand der Technik bekannt, ein Spray mit Hilfe von elektrischen Feldern in Richtung eines Substrats zu lenken. Dies ist das Grundprinzip der Elektrospraybeschichtung, wobei sich die geladenen Spraybestandteile entlang der Feldlinien bewegen und so auf einem Substrat abgeschieden werden. Auch ist aus dem Stand der Technik bekannt, ein Spray mit Hilfe von elektrischen Feldern zu formen. So verwenden Saf et al. in der oben genannten Publikation ein elektrostatisches Linsensystem, um aus einer Spraywolke einen schreibenden Materialstrahl zu erzeugen. Es ist allerdings bislang kein Verfahren bekannt, mit dem man während des Beschichtungsprozesses durch den Einfluss unmittelbar benachbarter Potenziale gezielt Einfluss auf die Form der abgeschiedenen Materialschicht nimmt. Die Strukturen können entweder gerade nach oben wachsen oder nach oben kleiner werden.

Der seitliche Abstand der einflussnehmenden benachbarten Strukturen liegt nahe bei der anziehend gepolten Struktur, auf der gesteuert abgeschieden werden soll. Ein Abstand zur anziehend gepolten Struktur, auf der abgeschieden werden soll, beträgt höchstens 1 cm, vorzugsweise weniger als 5 mm, in manchen Fällen auch weniger als 1 mm. Benachbarte Potenziale dienen nicht der strukturierten Abscheidung. Für die strukturierte Abscheidung ist die bereits vorstrukturierte leitfähige Struktur auf der abgeschieden wird verantwortlich. Die verwendeten benachbarten Potenziale dienen erfindungsgemäß in erster Linie der Formung der Seitenkanten der deponierten Schicht. Gewollte Abscheidungen auf einer Struktur sind nur die, die hinterher im fertigen Bauteil eine Funktion haben, z.B. als optische und/oder elektronische Funktionsschicht in einer OLED oder Solarzelle oder als Lichteinkoppel oder -auskoppelstruktur. Abscheidungen auf Strukturen, die im fertigen Bauteil keine Funktion übernehmen, dienten lediglich der Formung von gewollten Abscheidungen. Bei der Verwendung einer Maske als benachbartes Potenzial wird diese nach dem Beschichtungsvorgang entfernt. Damit wird in diesem Fall noch deutlicher, dass Beschichtungen auf der Maske lediglich eine Begleiterscheinung waren.

In einer Ausführungsform der Erfindung wird das Spray durch eine Maske mit einer Vielzahl von Öffnungen gelenkt, um eine Mehrzahl von dahinter liegenden, leitfähigen, anziehend gepolten Strukturen zeitgleich und damit in kurzer Zeit zu beschichten, die sich auf einer nicht-leitfähigen Unterlage befinden.

Anstelle einer Maske kann das Substrat, auf dem abgeschieden wird, eine Vielzahl von benachbarten Strukturen aufweisen, die während einer Beschichtung auf ein abstoßendes oder anziehendes Potenzial gebracht werden, um so zeitgleich Einfluss auf die laterale Verteilung der Materialdeposition auf einer Vielzahl von während der Abscheidung anziehend gepolten Strukturen zu nehmen. Die benachbarten Strukturen sind in der Nachbarschaft der auf anziehendes Potenzial gebrachten Strukturen angeordnet, auf denen abgeschieden werden soll. Wiederum kann so die Geometrie der Oberfläche des abgeschiedenen Materials für eine Vielzahl von verschiedenen, während der Abscheidung anziehend gepolten Strukturen zeitgleich gesteuert bzw. eingestellt werden.

Werden die vorgenannten benachbarten, auf dem Substrat aufgebrachten Strukturen während der Durchführung des Verfahrens in Bezug auf das Spray abstoßend gepolt, so werden nur die auf anziehendes Potenzial gebrachten Strukturen beschichtet. Eine Abdeckung von nicht-leitfähigen oder abstoßend gepolten Bereichen ist dafür also nicht erforderlich.

Die Elektrospraybeschichtung kann unter Normaldruck stattfinden. Eine teure Vakuumtechnik ist nicht erforderlich. Nahezu alles versprühte Material wird auf dem Bauteil bzw. Substrat abgeschieden, wenn benachbarte Strukturen während der Abscheidung abstoßend gepolt worden sind. Es ist daher dann ein besonders materialsparender Umgang mit regelmäßig teuren Beschichtungsmaterialien gewährleistet.

Selbst wenn benachbarte Strukturen während einer Abscheidung anziehend gepolt wurden, so werden diese zwar dann ebenfalls beschichtet. Allerdings wird nicht die gesamte Umgebung mit verschmutzt, wie das bei Vakuumsublimation und anderen Beschichtungsverfahren häufig der Fall ist. Das Verfahren ist daher unabhängig von den Potenzialen deutlich materialsparender im Vergleich zur thermischen Sublimation oder einem Aufschleuderverfahren.

Ein weiterer besonderer Vorteil liegt auch darin, dass das Beschichtungsverfahren im Gegensatz zu vielen anderen Aufbringungsmethoden wie Vakuumsublimation oder Aufschleudern als kontinuierliches Beschichtungsverfahren verwendet werden kann und damit für kontinuierliche Rolle-zu-Rolle Herstellungsprozesse geeignet ist. Substrate werden dann kontinuierlich an einer Sprayvorrichtung oder an einer Anordnung von mehreren Sprayvorrichtungen vorbei bewegt.

Ein weiterer Vorteil der strukturierten Elektrospraybeschichtung liegt darin, dass auch unebene Oberflächen wie z. B. gebogene oder gewellte Oberflächen gesteuert beschichtet werden können und zwar unter Einhaltung einer hohen Schichtdickengenauigkeit und unter gezielter Formung der Kanten. Dies ist mit anderen Techniken bisher nicht oder nur sehr eingeschränkt möglich. Das Verfahren dient daher in einer Ausführungsform der Beschichtung von Oberflächen, die keine glatte, ebene Oberfläche aufweisen.

Eine Beschichtungslösung besteht aus dem aufzubringenden Material und einem Lösungsmittel. Das Lösungsmittel kann aus einer Komponente oder aus einer Mischung verschiedener Lösungsmittel und/oder Additive bestehen. Das Lösungsmittel kann einerseits das aufzubringende Material lösen und ist andererseits leitfähig genug, um elektrostatisch - unter Umständen mit pneumatischer Unterstützung- zerstäubt werden zu können. Das Lösungsmittel bzw. Gemisch wird so zusammengesetzt, dass die jeweils gewünschte Morphologie der abgeschiedenen Schicht erreicht wird. Für eine eher pulverige Abscheidung werden Lösungsmittel verwendet, die schnell verdampfen, so dass der gelöste Stoff als relativ trockener Festkörper auftrifft. Soll das abgeschiedene Material noch nach dem Auftreffen zusammen laufen, sind eher Lösungsmittel zu verwenden, die langsamer verdampfen. Außer den Lösungsmitteln können diese Parameter auch durch den Abstand zwischen Spraykapillare und zu beschichtender Elektrode beeinflusst werden. Bei großem Abstand kann mehr Lösungsmittel verdunsten und das Material wird trockener abgeschieden und umgekehrt. Die Parameter können durch den Lösungsmittelgehalt, die Temperatur der Umgebungsatmosphäre eingestellt werden. Bei hoher Temperatur und/ oder niedrigem Lösungsmittelgehalt in der Atmosphäre kann relativ viel Lösungsmittel verdunsten und das Material in der Beschichtungslösung wird entsprechend trockener abgeschieden und umgekehrt.

Als Lösungsmittel eignen sich z.B. Chloroform, Chlorbenzol, Dichlorbenzol, Trichlorbenzol, Methanol, Ethanol, Propanol, iso-Propanol, DMF, DMSO, Toluol, Xylol, Dichlormethan, Acetonitril, THF. Dies sind nur Beispiele. Das Verfahren ist nicht auf diese Lösungsmittel beschränkt.

Es gibt auch weitere Parameter, die die Morphologie des abgeschiedenen Materials beeinflussen. Neben der oben schon genannten Flüchtigkeit des Lösungsmittels bzw. des Lösungsmittelgemisches, dem Abstand von Spraykapillare und zu beschichtender Elektrode und dem Lösungsmittelgehalt der umgebenden Atmosphäre hat auch die Menge und Eigenschaft des gelösten Beschichtungsmaterials (Glasübergangstemperatur, Viskosität, Tendenz zum Kristallisieren) Einfluss auf die Morphologie der erzeugten Beschichtung. So können unterschiedlichste Schichtmorphologien (z.B. glatt, rau, porös, pudrig, faserig, Kugelhaufen, verschiedene Flockenformen, Kristallite, etc.) durch Einstellen der hierfür optimalen Spraybedingungen eingestellt werden.

Beispiele hierfür sind z.B. in den Druckschriften "I.B. Rietveld, K. Kobayashi, H. Yamada, K. Matsushige, Electrospray deposition, model, and experiment: Toward general control of film morphology, Journal of Physical Chemistry B 2006, 110 (46), 23351-23364", "I.B. Rietveld, K. Kobayashi, H. Yamada, K. Matsushige, Morphology control of poly(vinylidene fluoride) thin film made with electrospray, Journal of Colloid and Interface Science 2006, 298 (2), 639-651", "J.W. Xie, L.K. Lim, Y.Y. Phua, J.S. Hua, C.H. Wang, Electrohydrodynamic atomization for biodegradable polymeric particle production, Journal of Colloid and Interface Science 2006, 302 (1), 103-112" genannt. Außerdem kann die Morphologie der entstandenen Schichten durch Nachbehandlungsschritte noch verändert werden.

Die Bestandteile des Sprays treffen wie oben beschrieben je nach gewünschter Schichtmorphologie mit mehr oder weniger Lösungsmittelgehalt als Tropfen, feuchte Partikel oder trockene Partikel auf der zu beschichtenden Elektrode, also auf der während der Abscheidung anziehend gepolten Struktur auf. Hier verdampft dann weiteres Lösungsmittel. Wenn nicht gewünscht ist, dass das auftreffende Material verläuft, werden die Randbedingungen bei der Beschichtung so gewählt, dass das Material nicht derart flüssig auf der Elektrode ankommt, dass es noch verlaufen könnte. Dies wird u. a. durch die einstellbare Geschwindigkeit der Lösungsmittelverdampfung, durch die Flüchtigkeit der verwendeten Lösungsmittel, den Lösungsmittelgehalt, Temperatur der Umgebung und/ oder Temperatur der zu beschichtenden Elektrode gesteuert. Außerdem kann dies durch den Abstand zwischen Sprayursprung und Elektrode, die Flußrate zur Spraykapillare und damit die Geschwindigkeit der Beschichtung, den Materialgehalt in der Spraylösung beeinflusst werden.

Für die Erzielung glatter Schichten mit ebenen Oberflächen ist es erwünscht, dass das Material in geeigneter Weise zusammen läuft. Hierbei ist eine geeignete Viskosität des auf der Elektrode ankommenden Materials hilfreich, die zum Beispiel durch den Lösungsmittelgehalt oder eine Temperatur, die über der Glasübergangstemperatur und Viskosität des Beschichtungsmaterials liegt, beeinflusst wird.

In einer Ausführungsform der Erfindung werden verschiedene, beispielsweise benachbarte leitfähige Strukturen mit unterschiedlichen Materialien und/oder Schichtdicken bedeckt, wobei die jeweiligen Strukturen nacheinander beschichtet werden. Während der Beschichtung einer Struktur oder Gruppe von Strukturen werden nur diese auf anziehendes Potenzial zwecks gesteuerter Abscheidung gelegt. Im Anschluss daran wird ausschließlich eine nächste Struktur oder eine nächste Gruppe von Strukturen auf anziehendes Potenzial gelegt und mit einem gewünschten anderen Material oder einer gewünschten anderen Schichtdicke beschichtet. Es wird dann Material auf oder oberhalb einer solchen elektrisch leitfähigen Struktur oder von solchen leitfähigen, zu der entsprechenden Gruppe gehörenden Strukturen abgeschieden. Während einer jeden Beschichtung werden die Strukturen, die nicht beschichtet werden sollen, auf abstoßendes Potenzial gebracht. Diese Ausführungsform kann z.B. für die Herstellung von Farbdisplays verwendet werden. Hierbei wird jede der unterschiedlichen Farben nur auf der jeweils gewünschten und anziehend gepolten Struktur bzw. anziehend gepolten Strukturen flächig abgeschieden.

Ein andere Anwendungsmöglichkeit liegt in der Herstellung einer Vielzahl von verschiedenen Schichtdicken, Materialien oder Materialkombinationen auf einer Unterlage bzw. einem Substrat. So können Versuchsreihen schneller und unter besser vergleichbaren Bedingungen durchgeführt werden (High-Throughput-Screening).

In einer Ausführungsform der Erfindung werden in einem Beschichtungsschritt unterschiedliche Schichtdicken aufgebracht, in dem die entsprechenden leitfähigen Strukturen des Substrats, die gesteuert beschichtet werden sollen, unterschiedlich lang auf anziehendes Potenzial gebracht und gehalten werden. In einer Ausführungsform werden zu diesem Zweck Kontaktierungen von elektrisch leitfähigen Strukturen oder Elektroden so verändert, dass elektrisch leitfähige Strukturen bzw. Elektroden eines Substrats in gewünschter Weise länger oder kürzer auf anziehendem Potenzial belassen werden. Je länger eine Struktur während einer Abscheidung auf anziehendem Potenzial gehalten wird, desto dicker ist grundsätzlich die daraus resultierende Schichtdicke. Ein Beispiel hierfür ist das oben genannt High-Throughput Screening, wobei mehrere Tests gleichzeitig durchgeführt werde können, um so schneller optimieren zu können. Ein anderes Beispiel ist die Erzielung unterschiedlicher Farben durch unterschiedliche Schichtdicken aufgrund des sogenannte Cavity-Effekts wie in der Patentanmeldung PCT/EP2009/063422 offenbart wird. Dies kann ausgenutzt werden, um mit einem Material unterschiedliche Farben zu erzielen, so z.B. für Displayanwendungen o.ä.

Wie breit die abzuscheidende Schicht auf oder oberhalb einer elektrisch leitfähigen Struktur wird, wird erfindungsgemäß u. a. durch die anliegenden Potenziale auf der bzw. den zu beschichtenden Strukturen sowie den Potenzialen der benachbarten, nicht-zu beschichtenden Strukturen beeinflusst. So kann gesteuert werden, ob auf einer zu beschichtenden, beispielsweise bahnförmigen Struktur nur ein schmaler Steg an Material abgeschieden wird oder eine so breite Schicht, dass eine bahnförmige elektrisch leitfähige Struktur mit ihren Randbereichen vollständig bedeckt ist.

Auf diese Weise kann eine drei-dimensional strukturierte Abscheidung von Material flächig über einen größeren Bereich gleichzeitig erfolgen. Es können so z.B. eine Vielzahl von Lichtleiterbahnen mit halbzylinderförmigem, dreieckigem oder stufenförmigem Querschnitt oder von halbkugelförmigen, kegelförmigen oder stufenförmigen Linsenkörpern abgeschieden werden. Solche langgezogenen Strukturen (liegende Halbzylinder, Dreieckssäulen, etc) können z.B. als Lichtwellenleiter dienen oder, wenn eine Vielzahl davon nebeneinander angeordnet sind, als optische Gitter, als Lichtein- und auskoppelstrukturen. Eine Vielzahl von Einzelkörpern kann ebenfalls als Lichtein- bzw. Auskoppelstruktur dienen oder als photonische Kristalle, die eine Vielzahl von optischen Effekten wie z.B. Lasing, ASE = Amplified Stimulated Emission ermöglichen. Die Breite und Höhe der aufgebrachten Schichten können kontinuierlich variiert werden, so dass außer der lateralen Strukturierung auch eine Strukturierung in der Höhe erfolgen kann. So können ohne lithographische Schritte und ohne schreibende Verfahren dreidimensionale Strukturen in gewünschter Weise abgeschieden werden (rapid prototyping, Stereolithographie). Stereolithographie bedeutet, durch frei im Raum materialisierende (Raster-)Punkte schichtenweise Strukturen aufzubauen; üblicherweise wird der Begriff genutzt, wenn man mit einem Laserstrahl Strukturen aus flüssigen, lichtaushärtenden Kunststoffen formt. Rapid-Prototyping sind Verfahren zur schnellen Herstellung von Musterbauteilen ausgehend von Konstruktionsdateien.

Zur Herstellung organisch elektronischer Bauteile wie z.B. organische Leuchtdioden, organische Solarzellen etc. kann eine strukturierte oder mikrostrukturierte Gegenelektrode (z.B. ITO) mit Hilfe des erfindungsgemäßen Elektrosprayverfahrens mit dem gewünschten OLED- oder Solarzellenmaterial beschichtet werden.

Ein zusätzlicher Vorteil für die Anwendung in der organischen Elektronik liegt z.B. darin, dass mit dem erfindungsgemäßen Verfahren bei der Herstellung von flächigen OLEDs auf die Reinigung der Randbereiche verzichtet werden kann, in dem diese Randbereiche nicht beschichtet werden, so dass eine bessere bzw. einfachere Verkapselung erzielt werden kann.

In einer Ausführungsform werden Randbereiche eines Bauteils nicht beschichtet und bleiben so zur anschließenden Verkapselung frei. Die Bauteile können zum Beispiel OLEDs oder Solarzellen sein. Typischerweise sind die aktiven Flächen von OLEDs und organischen Solarzellen in der Mitte einer Substratfläche angeordnet, während der Randbereich lediglich Elektroden zur Kontaktierung und Zuleitung zu den Elektrodenflächen in der Mitte des Substrates enthält. Der Randbereich weist zum Beispiel aus Metall oder aus transparenten leitfähigen Elektroden (TCO wie z.B. ITO) und/ oder freie, nicht-leitfähige Substratflächen auf. In diesen Randbereichen, die nicht die aktiven Flächen des Bauteils enthalten, kann die Verkapselung erfolgen.

Die Verkapselung dient dazu, das eigentliche Bauteil vor Umwelteinflüssen wie Sauerstoff oder Feuchtigkeit zu schützen. Um eine möglichst dichte Verkapselung zu erzielen, sollte die Verkapselung nicht auf den aktiven organischen Schichten eines Bauteils aufliegen. In dem Fall wäre die Verkapselung erfahrungsgemäß weniger dicht und das Bauteil weniger haltbar. Für eine optimale Verkapselung darf also der Randbereich des Bauteils, an dem, die Verkapselung sitzt, nicht mit organischem Material beschichtet sein. Wenn organische Schichten mittels Spincoating aufgebracht werden, was für PEDOT und Polymere eine übliche Beschichtungsmethode ist, wird dieser Randbereich automatisch mit beschichtet und muss vor eine Verkapselung aufwändig gereinigt werden. Da das erfindungsgemäße Sprayverfahren nur den Bereich der Elektrode beschichtet, bleiben die nicht-leitfähigen Randbereiche automatisch frei und müssen nicht mehr gereinigt werden. Es muss u.U. nur noch die leitfähige Zuleitung zur zu beschichtenden Elektrode bei der Spraybeschichtung abgedeckt werden.

In einer Ausführungsform der Erfindung werden die Potenzialverhältnisse während einer Beschichtung verändert, um dreidimensionale Strukturen wie Treppen, Linsen, liegende Halbsäulen etc. herzustellen. Dies ist selbst auf größeren Flächen ohne weitere lithographische Schritte oder "schreibende" Verfahren (wie z.B. Elektronenstrahldeposition oder stereolithographische Verfahren) möglich. Durch Veränderung der Potenziale der kontaktierten Struktur und/ oder der benachbarten Strukturen kann gesteuert werden, ob die komplette, leitfähige, zu beschichtende Struktur bedeckt wird, ob Randbereiche der leitfähigen Struktur frei bleiben oder ob Material nur im mittleren Bereich der Struktur abgeschieden wird. So kann z.B. im einfachsten Falls durch die Einstellung und Veränderung der anliegenden Potenziale an einer zu beschichtenden ITO-Bahn (also eine aus Indiumzinnoxid bestehende Bahn) und an benachbarten Bahnen gesteuert werden, ob nur ein schmaler Steg oder eine sehr breite Schicht abgeschieden wird.

In einer Ausführungsform der Erfindung werden organisch-elektronische Materialien nur auf leitfähige Flächen oder Strukturen einer Unterlage bzw. eines Substrats aufgebracht. Bei den leitfähigen Flächen oder Strukturen handelt es sich z. B. um transparente leitfähige Elektroden wie ITO oder um Metallschichten.

Als organisch-elektronische Materialien werden in einer Ausführungsform OLED-Materialien aufgetragen. Vorteilhaft wird nur der Bereich mit OLED-Materialien gemäß der Erfindung beschichtet, in dem das Bauteil leuchten soll. Benachbarte Bereiche, die nicht auf anziehendem Potenzial zur Sprayquelle liegen, bleiben frei.

Typische OLED Materialien sind z.B. die die in der WO 2005/109539 A1 offenbarten Materialgruppen und Materialien der hieraus bekannten Pufferschicht. Wir beziehen den Offenbarungsgehalt dieser Anmeldung in Bezug auf die genannten Materialien in die vorliegende Anmeldung ein.

In einer Ausführungsform werden niedermolekulare, vernetzbare Lochleiter als organisches Beschichtungsmaterial vorgesehen, so zum Beispiel die nachfolgend gezeigte Struktur auf der Basis von Triarylamin mit Oxetan als reaktiver Gruppe:

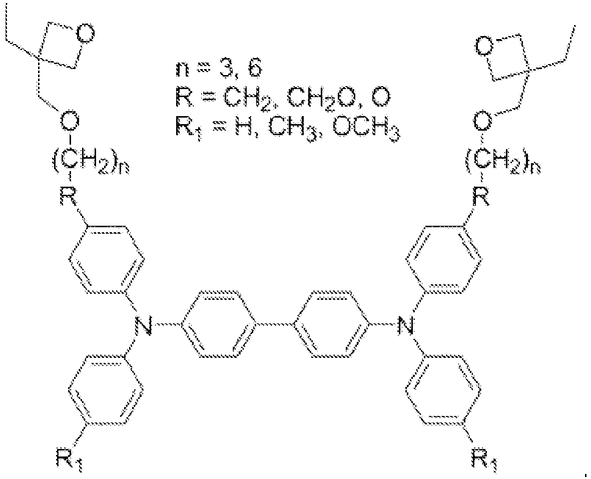

Weitere Beispiele für solche Materialien sind in den folgenden Strukturformeln dargestellt.

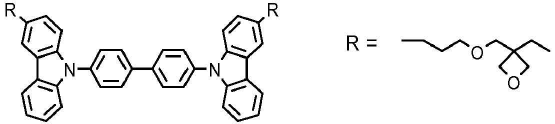

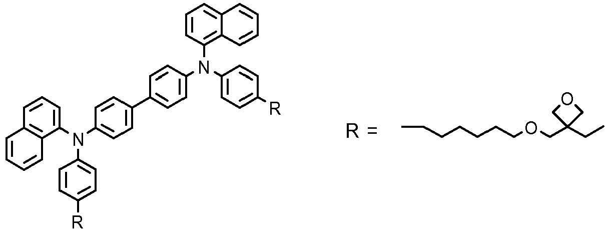

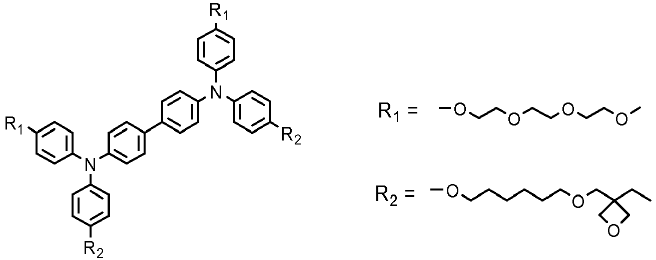

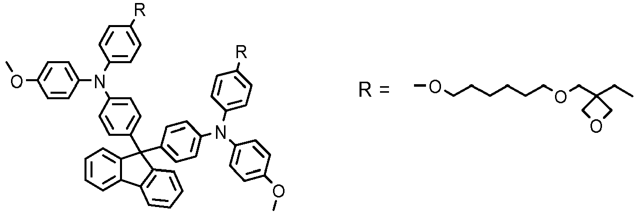

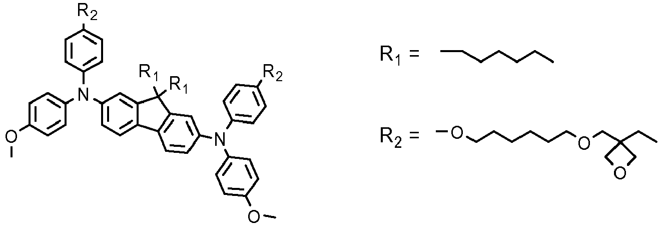

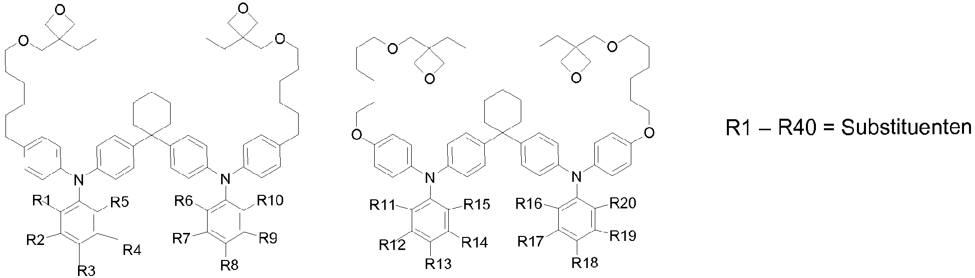

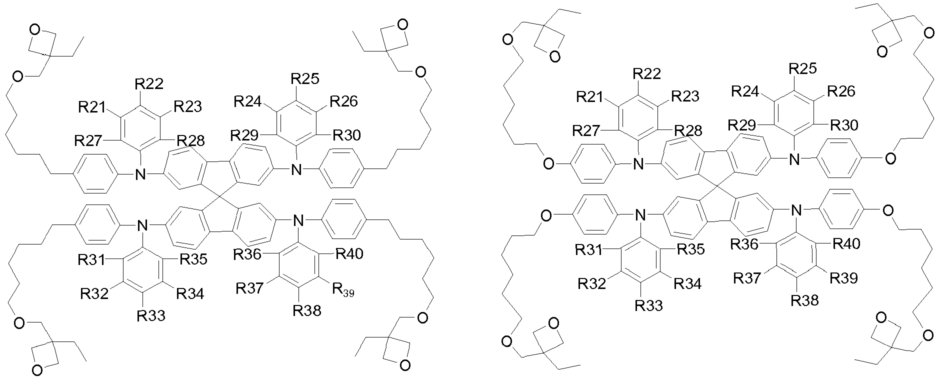

In einer anderen Ausführungsform der Erfindung werden niedermolekulare, oligomere oder polymere Lochleitermaterialien als organisches Beschichtungsmaterial vorgesehen, da so Produktionsbedingungen im Vergleich zu den niedermolekularen, vernetzbaren Lochleiter vereinfacht werden können. Ursächlich dafür sind die guten Filmbildungseigenschaften von oligomeren oder polymeren Lochleitermaterialien

Beispiele für niedermolekulare Lochleiter sind 4,4',4"-Tris(carbazol-9-yl)triphenylamin, α-NPD, Spiro-TAD, TPD, MTOATA, Carbazol-enthaltende Triplett-Matrices, etc.

Nachfolgend wird die chemische Struktur von oligomeren, vernetzbaren Lochleitern auf der Basis von Triarylamin mit Oxetan als reaktiver Gruppe gezeigt.

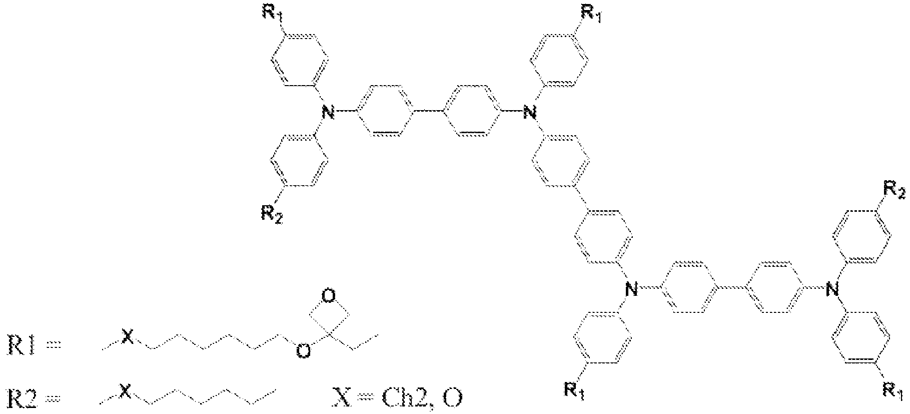

Nachfolgend wird die chemische Struktur von polymeren, vernetzbaren Lochleitern auf der Basis von Triarylamin mit Oxetan als reaktiver Gruppe gezeigt.

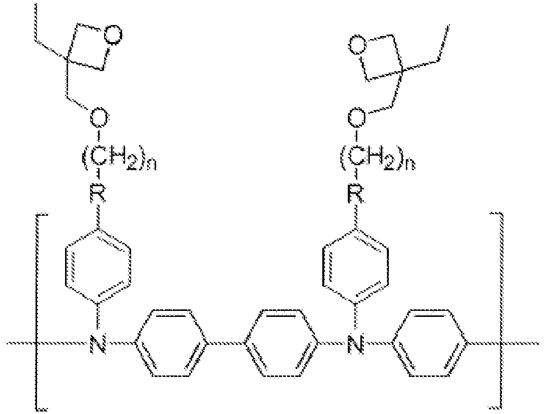

Weitere Beispiele für polymere Lochleitermaterialien sind im Folgenden aufgeführt:

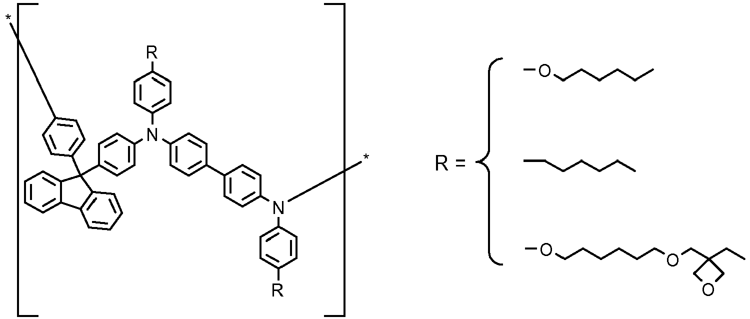

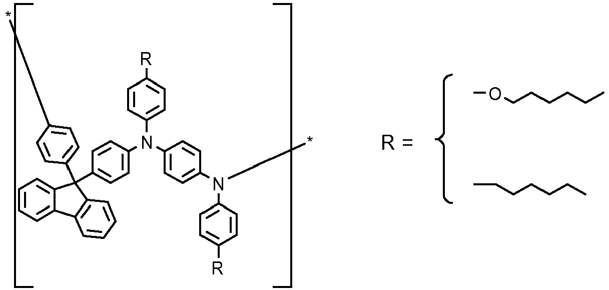

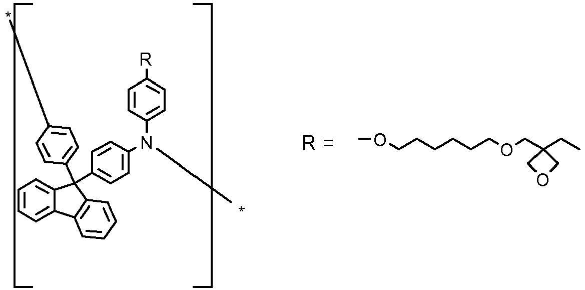

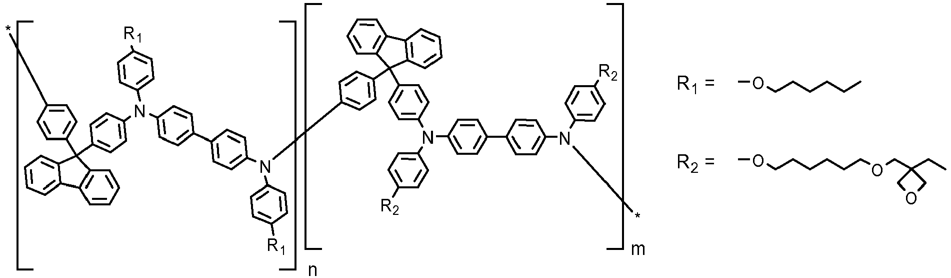

In einer Ausführungsform der Erfindung werden nach der Beschichtung die hergestellte(n) Schicht(en) vernetzt, was die mechanische Stabilität und Belastbarkeit der hergestellten Schicht(en) erhöht.

In einer anderen Ausführungsform wird ein intrinsisch leitfähiges Polymer wie z.B. PEDOT oder Polyanilin zur Beschichtung verwendet.

In einer anderen Ausführungsform werden niedermolekulare, oligomere und polymere Emittermaterialien zur Beschichtung verwendet. Beispiele hierfür sind kleine Moleküle wie z.B. Tris-(8-hydroxy-chinolinato)-aluminium (Alq3), Tris(2-phenyl-pyridyl)iridium Komplex, Carbazolmatrix + Metallkomplex wie z.B. Ir(Py)₃, etc. oligomere Emitter oder polymere Emitter z.B auf PolyPhenylen-Vinylen (PPV)-Basis oder auf Fluoren-Basis wie beipielsweise MEH-PPV, MDMO-PPV, Super Yellow, etc.

Weitere Beispiele sind im Folgenden gezeigt:

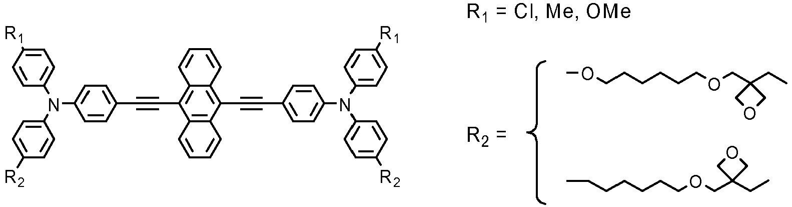

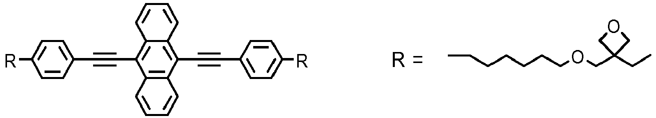

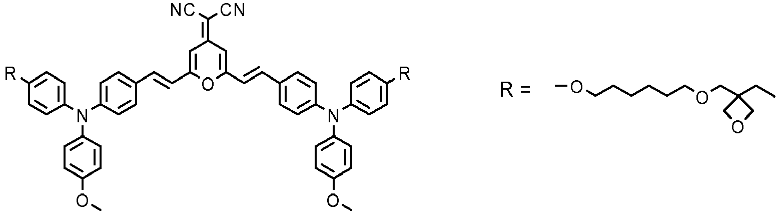

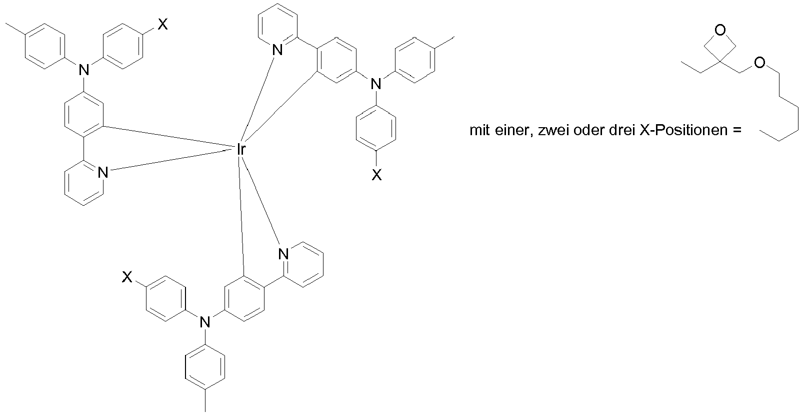

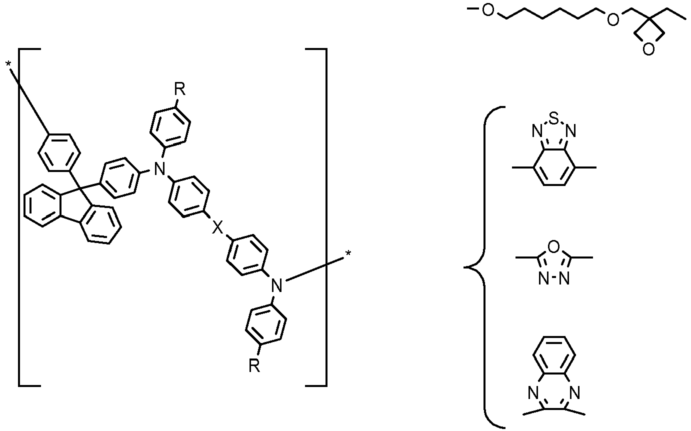

In einer Ausführungsform werden niedermolekulare, oligomere oder polymere Absorbermaterialien oder Matrixmaterialien als organisches Beschichtungsmaterial vorgesehen. Im Folgenden werden Beispiele hierfür gezeigt.

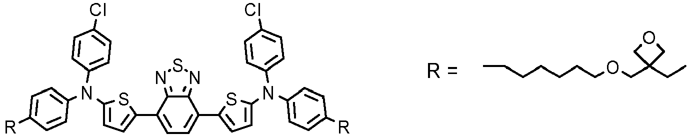

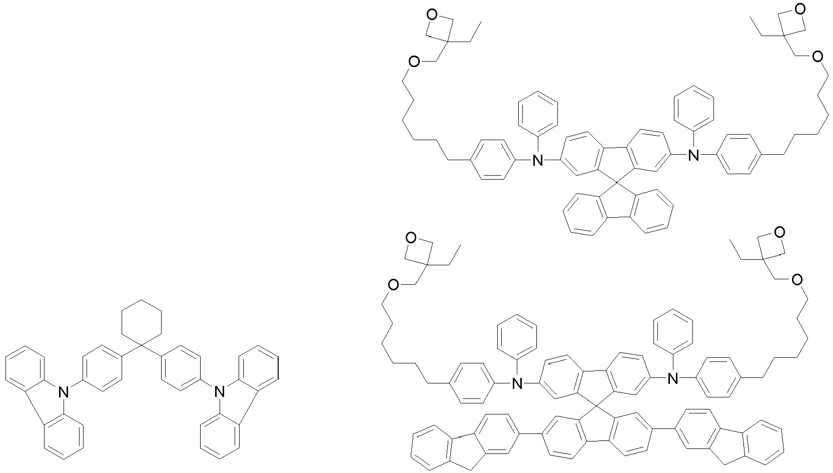

In einer Ausführungsform werden niedermolekulare, oligomere oder polymere Elektrontransportmaterialien wie z.B. 2-(4-Biphenyl)-5-(4-tert-butylphenyl)-1,3,4-oxadiazol, 1,3,4-Oxadiazol 2,2'-(1,3-phenylen)bis(5-(1-(1,1-dimethylethyl)phenyl)), Polyfluorene, Fullerene wie z.B. PCBM oder PCBM-Multiaddukt etc. als organisches Beschichtungsmaterial vorgesehen.

In einer anderen Ausführungsform werden photovoltaisch aktive Materialien oder Materialmischungen zur Beschichtung verwendet. Hierbei kommen beispielsweise Elektronenakzptormaterialien wie Fullerenderivate oder Elektronendonormaterialien wie Thiophenderivate oder andere N- oder S-Heterocyclen in Frage.

Beispiele für Elektronenakzeptormaterialien sind Fullerenderivate wie C₆₀, C₆₁-butyric acid methyl ester (PCBM), PCBM-Multiaddukt, etc.

Beispiele für Elektronendonormaterialien sind Poly-(3-hexyl)-thiophen (P3HT), (MDMO-PPV), Thiophenderivate oder andere N- oder S- Heterocyclen, Farbstoffe wie Rylenfarbstoffe und Merocyaninfarbstoffe, Farbstoffe, die Metallkomplexe enthalten, etc.

Die Verwendung oxetan-vernetzbarer Materialien ist besonders vorteilhaft aufgrund ihrer guten Filmbildungseigenschaften, aufgrund der Möglichkeit, die erzeugten drei-dimensionalen Strukturen anschließend durch Vernetzung zu fixieren und aufgrund des geringen Volumenschrumpfes bei der Vernetzung über Oxetane, so dass Rissbildungen während der Vernetzung reduziert oder vermieden werden.

Neben den genannten elektrisch und/oder optisch aktiven Materialien können auch beliebige nicht-aktive Materialien verwendet werden.

Neben den genannten Materialien in den verschiedenen Ausführungsformen können auch Mischungen dieser oder ähnlicher Materialien verwendet werden. Die genannten Materialien sind nur Beispiele. Die Erfindung ist nicht auf diese genauen Materialien beschränkt.

Bei der Herstellung von OLED-Displays kann die Aufbringung von unterschiedlichen Farben nach dem erfindungsgemäßen Verfahren ohne teure Hochvakuumschritte oder Lithographieschritte unter Normaldruck erfolgen. Dabei werden die einzelnen leitfähigen Bahnen (z.B. ITO, andere TCOs oder Metallbahnen) zur Herstellung von Displays separat kontaktiert. Nur die Bahnen, die jeweils beschichtet werden sollen, werden auf ein entsprechendes anziehendes Potenzial gelegt. In einer Ausführungsform werden zu diesem Zweck auf verschiedenen elektrisch leitfähigen Strukturen eines Substrats nacheinander unterschiedliche Materialien aufgebracht. In einem ersten Schritt werden dann die jeweils mit einer Farbe zu beschichtenden Pixel gleichzeitig anziehend gepolt und beschichtet. Die anderen Pixel, die nicht mit dieser Farbe beschichtet werden sollten, werden während der Abscheidung abstoßend gepolt. In einem zweiten Schritt werden auf eine zweite Gruppe von Pixeln Materialien mit einer gewünschten zweiten Farbe in analoger Weise deponiert. In einem dritten Schritt werden auf eine dritte Gruppe von Pixeln Materialien mit einer gewünschten dritten Farbe in analoger Weise deponiert. Insbesondere werden während eines zweiten und dritten Schritts auch die zuvor bereits beschichteten Pixel abstoßend gepolt, die daher nicht mehr mit einer neuen Farbe beschichtet werden sollen. Wiederum findet die Elektrospraybeschichtung unter Normaldruck statt, so dass daher keine teure Vakuumtechnik notwendig ist.

Wenn verschiedene benachbarte Bereiche mit unterschiedlichen Materialien oder Schichtdicken bedeckt werden sollen, werden also die jeweiligen Bereiche nacheinander beschichtet, in dem immer nur der jeweils zu beschichtende Bereich auf anziehendes Potenzial gelegt wird. Andere Bereiche, die nicht beschichtet werden sollen, werden dann grundsätzlich auf abstoßendes Potenzial gebracht und zwar vor allem dann, wenn keine abstoßend gepolte Maske verwendet werden soll.

Durch Variation der Potenzialverhältnisse (Potenziale der kontaktierten Struktur und der benachbarten Strukturen) werden in einer Ausführungsform der Erfindung auf einer Substratoberfläche gleichzeitig eine Vielzahl dreidimensionaler Strukturen wie Treppen, Linsen, Zylinderlinsen, liegende Halbsäulen etc. aufgebracht, die sonst in der Regel nur mit "schreibenden" Verfahren (Elektronenstrahldeposition, Stereolithographie) hergestellt werden können.

Durch Variation der Potenzialverhältnisse (Potenziale der kontaktierten Struktur und der benachbarten Strukturen) werden in einer Ausführungsform auf größeren Flächen leitfähige Strukturen mehr oder weniger stark bedeckt. So werden z.B. die Bedingungen so eingestellt, dass der Randbereich der leitfähigen Struktur frei bleibt und Material nur im mittleren Bereich der Struktur abgeschieden wird, oder so, dass die leitfähige Struktur komplett bedeckt wird. Unter bestimmten Bedingungen wird auch der Randbereich komplett beschichtet.

### Es zeigen

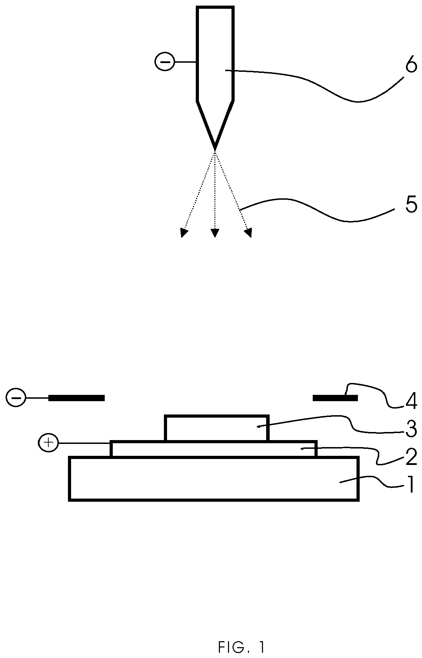

Figur 1 zeigt ein aus Glas bestehendes Substrat 1 mit einer darauf befindlichen, aus Indiumzinnoxid (ITO) bestehenden Elektrode 2. Auf der Elektrode 2 wird eine Schicht 3 abgeschieden. Zu diesem Zweck befindet sich oberhalb des Substrats 1 eine Maske 4. Die Maske 4 verfügt über einen Durchlass, durch den ein Spray 5 hindurchtreten kann, um so zur Elektrode 2 zu gelangen. Das Spray 5 tritt aus einer Elektrode 6 aus und wird durch diese beispielsweise negativ aufgeladen. Wurde das Spray negativ aufgeladen, so wird die Elektrode 2 auf ein demgegenüber anziehendes Potenzial, also auf ein weniger stark negatives Potenzial, auf Erdpotenzial oder auf positives Potenzial gebracht, um so zu erreichen, dass das Spray möglichst vollständig zur Elektrode 2 gelangt. Im Spray befindliches Schichtmaterial wird auf der Elektrode 2 auf diese Weise abgeschieden. Mithilfe eines an der Maske 4 angelegten Potenzials wird die Abscheidung auf der Elektrode 2 gesteuert.

In einem Ausführungsbeispiel wurde eine auf einem Glas-Substrat aufgebrachte ITO-Bahn mit einer Höhe von ca. 130 nm und einer Breite von ca. 15 mm beschichtet. Es wurde eine Edelstahl-Spraykapillare mit 260 *µ*m Außendurchmesser und 130 *µ*m Innendurchmesser und plan geschliffenem Auslass eingesetzt. Der Abstand der Spraykapillare zum Substrat betrug 4 cm. An die Spraykapillare wurde ein Potenzial von 5 kV angelegt. Das an die zu beschichtende Bahn angelegte Potenzial betrug 0V (Erde). Der Abstand der Maske zur Substratoberfläche betrug ca. 300*µ*m. Je nach Abstand müssen die anliegenden Potenziale an der Maske und der zu beschichtenden Elektrode fein justiert werden, um das gewünschte Ergebnis zu erhalten. Die Maske bestand aus 0,3 mm dickem Messingblech mit einer streifenförmigen Öffnung in der Maske von 16 mm Breite und 20 mm Länge.

Als Spraylösung/Beschichtungsmaterial wurde eingesetzt: 2 mg/ml triphenylamin-basierter Lochleiter, N,N'-bis(4-[6-[(3-ethyloxetane-3-yl)methoxy]-hexylphenyl]-N,N'-diphenyl-4,4'-diamine und als Lösungsmittel: Dichlormethan, Tetrahydrofuran, Acetonitril im Verhältnis 2:1:0,9. Die Beschichtungsdauer betrug 15 min, die Flussrate, mit der die Spraylösung der Kapillare zugeführt wurde betrug 2 *µ*l/min. Das Potenzial der Maske wurde auf -75V gelegt und das Potenzial des ITO-Streifen auf 0V. Wichtig war die Differenz zwischen den Potenzialen von ITO-Streifen und Maske, nicht aber die Absolutwerte. Der ITO-Streifen wurde so komplett mit einer Schichtdicke von ca. 50 nm beschichtet. Es traten keine nachteiligen Überhöhungen der Randbereiche auf.

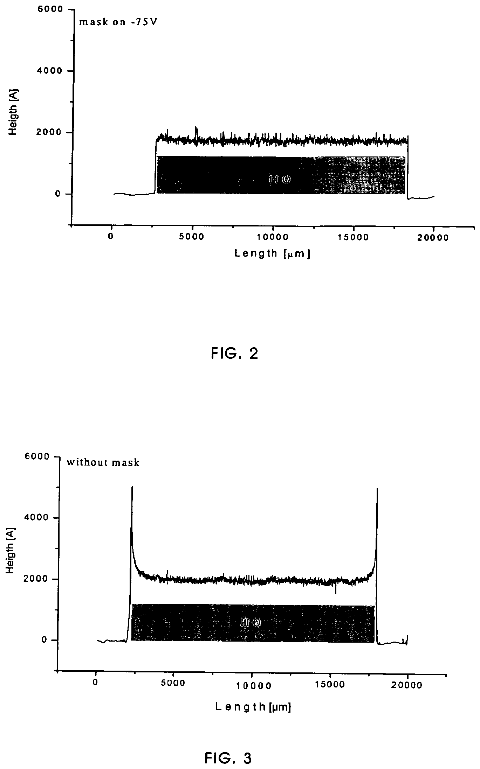

Figur 2 zeigt das profilometrisch gemessene Höhenprofil der so erzeugten Streifenstruktur ohne Randüberhöhung, die auf einem ITO-Streifen auf einer nicht-leitfähigen Unterlage (Glas) abgeschieden wurde.

In einem weiteren Ausführungsbeispiel wurde im Gegensatz zum Ausführungsbeispiel von Fig. 2 keine Maske verwendet. Alle anderen Beschichtungsparameter waren gleich. Durch das abstoßende Potenzial, das die nicht-leitfähigen Bereiche neben dem ITO-Streifen während der Spraybeschichtung verursachen (Ladung der wenigen unbeabsichtigt auftreffenden Spraybestandteile kann nicht abfließen und generiert so ein abstoßendes Potenzial), entsteht eine nachteilige Überhöhung im Randbereich. Es resultiert in der Mitte eine Schichtdicke von ca. 70 nm.

Figur 3 zeigt das profilometrisch gemessene Höhenprofil der so erzeugten Streifenstruktur mit nachteiliger Randüberhöhung, die auf einem ITO-Streifen auf einer nicht-leitfähigen Unterlage (Glas) abgeschieden wurde.

In einem weiteren Ausführungsbeispiel wurde im Gegensatz zum Ausführungsbeispiel von Fig. 2 die Maske auf -50V gelegt. Alle anderen Beschichtungsparameter waren gleich. Durch die teilweise Umlenkung der Spraywolke auf die Maske wurde die Randüberhöhung schon abgemildert, aber noch nicht vollständig egalisiert. Es resultierte eine Schichtdicke in der Mitte von ca. 60 nm.

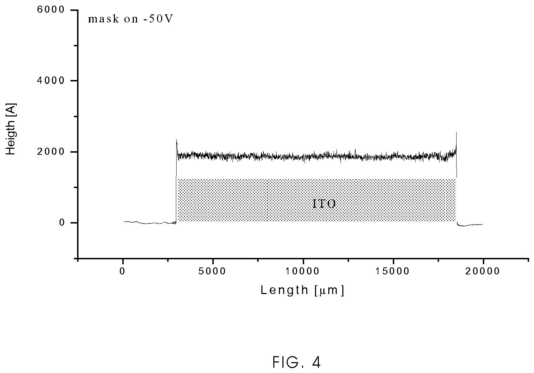

Figur 4 zeigt das profilometrisch gemessene Höhenprofil der so erzeugten Streifenstruktur mit reduzierter Randüberhöhung, die auf einem ITO-Streifen auf einer nicht-leitfähigen Unterlage (Glas) abgeschieden wurde.

In einem weiteren Ausführungsbeispiel wurde im Gegensatz zum Ausführungsbeispiel von Fig. 2 die Maske auf -100V gelegt. Alle anderen Beschichtungsparameter waren gleich. Die Maske wirkt nun sehr stark anziehend auf die Spraywolke. Es wird hier soviel Material vom Randbereich der Struktur auf die nun stärker anziehende Maske umgelenkt, dass die Ränder der leitfähigen Struktur nicht mehr beschichtet werden und freibleiben. Es resultierte eine Schichtdicke in der Mitte von ca. 30 nm.

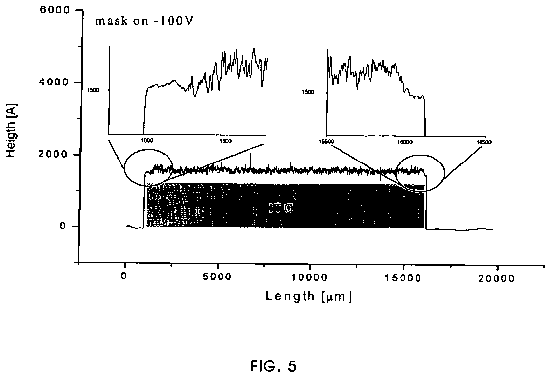

Figur 5 zeigt das profilometrisch gemessene Höhenprofil der so erzeugten Streifenstruktur mit reduzierter Randüberhöhung, die auf einem ITO-Streifen auf einer nicht-leitfähigen Unterlage (Glas) abgeschieden wurde.

Gleiche Effekte sind aber auch von Strukturen mit 250 *µ*m Breite gemessen worden und gelten auch für noch deutlich kleinere Strukturen.

Die Potenziale von Elektrode, Maske und Spray können jeweils auch umgekehrt sein. Dann ist das Spray positiv aufgeladen. Die Potenziale von Elektrode, Maske und Spray können auch alle positiv sein. Es ist nur wichtig, dass die Potenzialdifferenz so eingestellt ist, dass eine ausreichend hohe Potenzialdifferenz besteht um einen Spray zu bilden und dass das Spray entlang des Potenzialgradienten dorthin gelenkt wird, wo es abgeschieden werden soll.

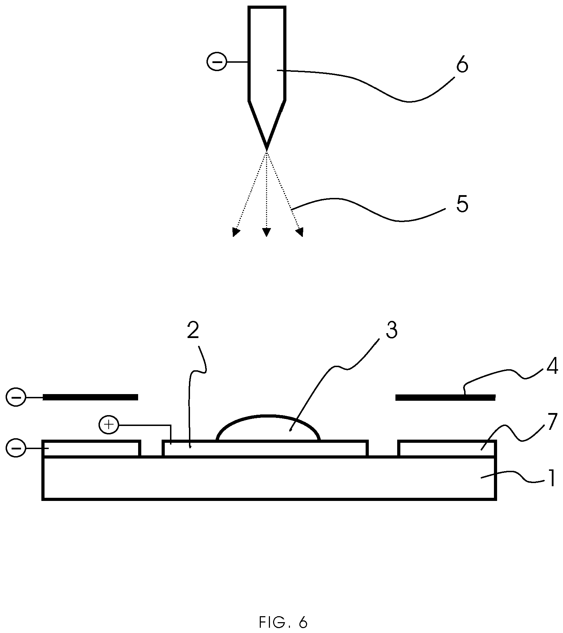

In der Figur 6 wird eine weitere Ausführungsform der Erfindung gezeigt. Wahlweise können statt der Maske 4 oder zusätzlich zur Maske 4 auch elektrisch leitende Strukturen 7 auf dem Substrat benachbart zur Elektrode 2 aufgebracht sein. Wurde das Spray 5 negativ aufgeladen, so werden die elektrisch leitfähigen Strukturen 4 oder 7 während der Beschichtung auf ein geeignetes Potenzial gebracht, um das Spray zu einem vorgesehenen Bereich auf der bezüglich zum Spray anziehend geladenen Elektrode 2 zu lenken. Figur 6 zeigt den Fall, dass das im Spray 5 befindliche Schichtmaterial auf der Elektrode 2 halbkreisförmig abgeschieden wird, in dem das Potenzial von Maske und/oder benachbarten leitfähigen Strukturen während der Beschichtung zunehmend abstoßender zum Spray eingestellt wird.

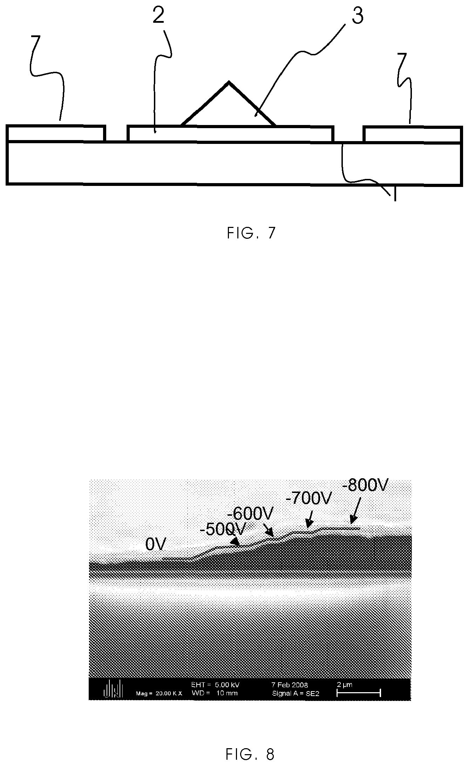

Figur 7 zeigt den Fall, dass erfindungsgemäß eine Schicht dreiecksförmig abgeschieden wurde.

Die in den Figuren gezeigten Geometrien sind spiegelsymmetrisch abgeschieden worden. Mit Hilfe der Erfindung ist es aber auch möglich, in nicht spiegelsymmetrischer Weise abzuscheiden. Zu diesem Zweck werden zum Beispiel an den Durchlass der Maske 4 angrenzende Bereiche auf unterschiedliche Potenziale gebracht oder der Durchlass der Maske 4 wird gegenüber der Elektrode 2 versetzt angeordnet.

Entsprechend kann mit Hilfe von leitfähigen Strukturen 7 eine nicht spiegelbildliche Abscheidung erhalten werden, indem also zum Beispiel eine erste leitfähige Struktur 7 auf ein anderes Potenzial gebracht wird als eine zweite gegenüberliegende leitfähige Struktur 7, die an die Elektrode 2 angrenzen.

In einem Ausführungsbeispiel wurden ITO-Bahnen beschichtet, die auf einem aus Glas bestehenden Substrat aufgebracht worden sind. Die ITO-Bahnen wiesen eine Höhe von ca. 130 nm auf und eine Breite von ca. 250 *µ*m. Zwischen den parallel verlaufenden Bahnen gab es 150 *µ*m breite Zwischenräume.

Es wurde eine Edelstahl-Spraykapillare mit einem Außendurchmesser von 260 *µ*m und einem Innendurchmesser von 130 *µ*m eingesetzt. Der Auslass der Edelstahl-Spraykapillare war plan geschliffen. Der Abstand der Spraykapillare zum Substrat betrug 5 cm. Das an der Spraykapillare angelegte Potenzial betrug 5 kV. Das angelegte Potenzial an der zu beschichtenden Bahn betrug 0V (Erde). Es kommt in einem solchen Fall nicht darauf an, auf welchem genauen Potenzial sich die einzelnen Bestandteile befinden. Es ist vielmehr die Potenzialdifferenz von Bedeutung, da diese einen Feldstärkegradienten erzeugt, entlang dem sich die geladenen Bestandteile aus der Spraywolke bewegen. Es ist außerdem wichtig, dass auftreffende Ladungsträger von der zu beschichtenden Elektrode abfließen können, damit sich hier kein unerwünschtes Gegenfeld aufbauen kann, das die eingestellten gewünschten Potenzialgradienten verändert. Das angelegte Potenzial an den benachbarten ITO-Bahnen wurde in zeitlichen Abständen von ca. 3 min von 0V, 500V, 600V, 700V, 800V verändert. Das Potenzial am Substrat und an der Edelstahl-Spraykapillare wurde mit einem Hochspannungsnetzteil erzeugt und mit Metallklemmen angelegt. Die Flussrate, mit der die Spraylösung der Kapillare zugeführt wurde, betrug 2 *µ*l/min. Als Spraylösung/Beschichtungsmaterial wurde eingesetzt: 2 mg/ml triphenylamin-basierter Lochleiter N,N'-bis(4-[6-[(3-ethyloxetane-3-yl)methoxy]-hexylphenyl]-N,N'-diphenyl-4,4'-diamine. Als Lösungsmittel wurde Dichlormethan, Chlorbenzol, Acetonitril im Verhältnis 2:1:0,9 eingesetzt. Die Beschichtungsdauer betrug insgesamt 15 Minuten. Auf diese Weise wurde stufenförmig in der aus der Figur 8 ersichtlichen Weise beschichtet. Figur 8 zeigt den Querschnitt durch eine so erzeugte Struktur.

In einem weiteren Ausführungsbeispiel wurden Metall-Bahnen beschichtet, die auf einem aus Glas bestehenden Substrat aufgebracht worden sind. Die Metall-Bahnen wiesen eine Höhe von ca. 200 nm auf und eine Breite von ca. 500 *µ*m. Zwischen den parallel verlaufenden Bahnen gab es ca. 500 *µ*m breite Zwischenräume.

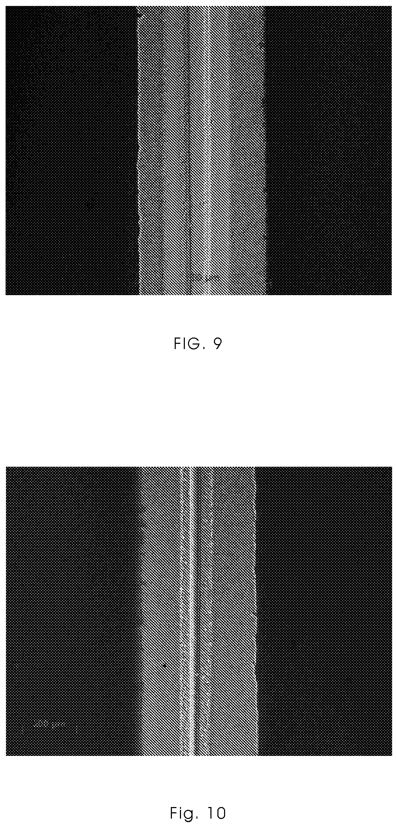

Es wurde eine Edelstahl-Spraykapillare mit einem Außendurchmesser von 260 *µ*m und einem Innendurchmesser von 130 *µ*m eingesetzt. Der Auslass der Edelstahl-Spraykapillare war plan geschliffen. Der Abstand der Spraykapillare zum Substrat betrug 4 cm. Das an der Spraykapillare angelegte Potenzial betrug 3,3 kV. Das angelegte Potenzial an der zu beschichtenden Bahn betrug 0V (Erde). Das angelegte Potenzial an den benachbarten Metall-Bahnen wurde in zeitlichen Abständen von ca. 5 min von 0V auf 500V auf 1000V verändert. Das Potenzial am Substrat und an der Edelstahl-Spraykapillare wurde mit einem Hochspannungsnetzteil erzeugt und mit Metallklemmen angelegt. Die Flussrate, mit der die Spraylösung der Kapillare zugeführt wurde, betrug 1,5 *µ*l/min. Als Spraylösung/Beschichtungsmaterial wurde eingesetzt: 2 mg/ml triphenylamin-basierter Lochleiter N,N'-bis(4-[6-[(3-ethyloxetane-3-yl)methoxy]-hexylphenyl]-N,N'-diphenyl-4,4'-diamine. Als Lösungsmittel wurde Ethanol eingesetzt. Die Beschichtungsdauer betrug insgesamt 15 Minuten. Auf diese Weise wurde stufenförmig in der aus der Figur 9 ersichtlichen Weise beschichtet. Fig. 9 zeigt eine mikroskopische Aufnahme der so erzeugten treppenförmigen Struktur.

Fig. 10 zeigt eine mikroskopische Aufnahme einer treppenförmigen Struktur, die erzeugt wurde, indem im Vergleich zu Fig. 9 das verwendete Lösungsmittel auf Isopropanol + 4 % Ameisensäure verändert wurde.

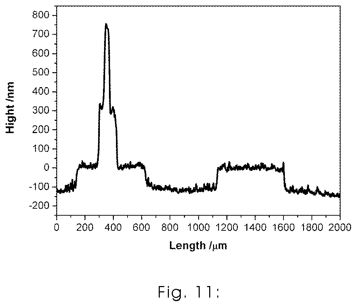

Fig. 11 zeigt die profilometrische Darstellung der so erzeugten Treppenstruktur (links) neben einer der Elektroden, die das abstoßende Potenzial erzeugt haben und daher unbeschichtet geblieben sind.

Die Stufenhöhe wird durch die Beschichtungsdauer eingestellt. Je länger beschichtet wird, um so höher wird eine Stufe.

Es ist auch umgekehrt möglich, 0V an benachbarten ITO-Bahnen anzulegen und an die zu beschichtender Bahn in entsprechenden zeitlichen Abständen 0V, -500V, -600V, -700V, -800V.

In einem weiteren Ausführungsbeispiel wurde eine auf einem Glas-Substrat aufgebrachte ITO-Bahn mit einer Höhe von ca. 130 nm und einer Breite von ca. 250 *µ*m beschichtet. Es wurde eine Edelstahl-Spraykapillare mit 260 *µ*m Außendurchmesser und 130 *µ*m Innendurchmesser und plan geschliffenem Auslass eingesetzt. Der Abstand der Spraykapillare zum Substrat betrug 5 cm. An die Spraykapillare wurde ein Potenzial von 5 kV angelegt. Das an die zu beschichtende Bahn angelegte Potenzial betrug 0V (Erde). Es wurde eine Maske eingesetzt. Der Abstand Maske zur Substratoberfläche wurde so klein wie möglich eingestellt. Die Maske lag also praktisch direkt auf dem Substrat auf. In diesem Fall war der Abstand 0 *µ*m. In anderen Fällen betrug der Abstand 250*µ*m oder 500 *µ*m. Je nach Abstand müssen die anliegenden Potenziale an der Maske und der zu beschichtenden Elektrode fein justiert werden, um das gewünschte Ergebnis zu erhalten. Die Maske bestand aus 0,2 mm dicken Edelstahl mit einer streifenförmigen Öffnung in der Maske von 3 mm Breite und 20 mm Länge.

Als Spraylösung/Beschichtungsmaterial wurde eingesetzt: 2 mg/ml triphenylamin-basierter Lochleiter, N,N'-bis(4-[6-[(3-ethyloxetane-3-yl)methoxy]-hexylphenyl]-N,N'-diphenyl-4,4'-diamine und als Lösungsmittel: Dichlormethan, Chlorbenzol, Acetonitril im Verhältnis 2:1:0,9. Die Beschichtungsdauer betrug für 20 nm ca. 4 Minuten. Die Flussrate, mit der die Spraylösung der Kapillare zugeführt wurde betrug 2 *µ*l/min. Das Potenzial der Maske wurde auf -50V gelegt und das Potenzial des ITO-Streifen auf 0V. Wichtig war die Differenz zwischen den Potenzialen von ITO-Streifen und Maske, nicht aber die Absolutwerte. Der ITO-Streifen wurde so komplett beschichtet. Es traten keine nachteiligen Überhöhungen der Randbereiche auf.

## Patentansprüche

1. Verfahren zur Beschichtung eines Substrats (1), wobei eine Flüssigkeit, die Beschichtungsmaterial enthält, mit Hilfe eines elektrischen Feldes zerstäubt wird, wobei die Flüssigkeit mit dem darin enthaltenen Beschichtungsmaterial als Spray aus einer Elektrode (6) austritt und durch diese elektrisch aufgeladen wird und eine elektrisch leitfähige Struktur (2) des Substrats während der Beschichtung auf ein solches elektrisches Potenzial gebracht wird, dass die zerstäubte Flüssigkeit (5) angezogen wird, wobei ein oder mehrere zusätzliche benachbarte Strukturen (4, 7) zur Steuerung der Oberflächengeometrie des abgeschiedenen Materials (3) vorhanden sind, die während der Beschichtung auf Potenzial gebracht werden und zwar auf ein Potenzial, welches die zerstäubte Flüssigkeit (5) abstößt, bei dem eine Maske (4) als benachbarte Struktur verwendet wird, **dadurch gekennzeichnet dass**, der Bereich der Spannung der Maske relativ zu dem Substrat -50V bis -100V beträgt.

2. Verfahren nach Anspruch 1, **dadurch gekennzeichnet**, ein oder mehrere Potenziale von ein oder mehreren benachbarten Strukturen (4, 7) so eingestellt und/ oder verändert werden, dass ein oder mehrere Schichten zeitgleich mit ebener Oberfläche auf ein oder mehreren anziehend gepolten Strukturen (2) des Substrats (1) abgeschieden werden.

3. Verfahren nach einem der vorhergehenden Ansprüche, bei dem eine anziehend gepolte Struktur (2) des Substrats (1) zeitgleich vollflächig beschichtet wird.

4. Verfahren nach einem der vorhergehenden Ansprüche, bei dem die Maske (4) eine Vielzahl von Öffnungen umfasst und hinter jeder Öffnung eine während der Beschichtung anziehend gepolte Struktur (2) vorhanden ist.

5. Verfahren nach einem der vorhergehenden Ansprüche, bei dem das Substrat (1) eine Vielzahl von elektrisch leitfähigen Strukturen (2) umfasst, die elektrisch voneinander getrennt sind, und bei dem während der Beschichtung nur ein Teil der elektrisch leitfähigen Strukturen (2) anziehend gepolt wird, so dass die zerstäubte Flüssigkeit (5) in Richtung dieser elektrisch leitfähigen Strukturen (2) gelenkt wird, und der andere Teil der elektrisch leitfähigen Strukturen (2) während der Beschichtung abstoßend gepolt wird.

6. Verfahren nach einem der vorhergehenden Ansprüche, bei dem mehrere Schichten (3) mit unterschiedlicher Schichtdicke erzeugt werden, indem während eines Beschichtungsschrittes auf dem Substrat (1) befindliche leitfähige Strukturen (2) unterschiedlich lang auf anziehendes Potenzial gebracht werden.

7. Verfahren nach einem der vorhergehenden Ansprüche, bei dem im Anschluss an die Beschichtung aus dem Bauteil ein Display, eine Leuchtdiode oder eine Solarzelle hergestellt wird.

## Claims

1. Method for coating a substrate (1), wherein a liquid, which contains coating material, is dispersed by means of an electrical field, wherein the liquid with the coating material contained therein leaves the electrode (6) as a spray and is electrically charged by it, and an electrically conductive structure (2) of the substrate is brought to such an electrical potential during the coating that the dispersed liquid (5) is attracted, wherein there are one or more additional neighbored structures (4, 7) for controlling the surface geometry of the deposited material (3), which are brought to a potential during the coating, specifically to a potential, which repels the dispersed liquid (5), wherein a mask (4) is used as neighbored structure, **characterized in that** the area of the voltage of the mask relative to the substrate is -50V to -100V.

2. Method of claim 1, **characterized in that** one or more potentials of one or more neighbored structures (4, 7) are adjusted and/or changed such that one or more layers are deposited simultaneously with a flat surface on one or more structures (2), which are polarized to attract, of the substrate (1).

3. Method of one of the proceeding claims, wherein a structure (2), which is polarized to attract, of the substrate (1) is simultaneously coated on its entire surface.

4. Method of one of the proceeding claims, wherein the mask (4) comprises a plurality of openings and behind each opening, there is a structure (2), which is polarized to attract during the coating.

5. Method of one of the proceeding claims, wherein the substrate (1) comprises a plurality of electrically conductive structures (2), which are electrically separated from each other, and wherein during coating only a part of the electrically conductive structures (2) is polarized to attract such that the dispersed liquid (5) is deflected in direction of this electrically conductive structures (2), and the other part of the electrically conductive structures (2) is polarized to repel during the coating.

6. Method of one of the proceeding claims, wherein several layers (3) with different layer thickness are generated by bringing conductive structures (2) arranged on the substrate (1) for a different time on an attracting potential during a coating step.

7. Method of one of the proceeding claims, wherein subsequent to the coating, a display, an illuminating diode or a solar cell is made from the element.

## Revendications

1. Procédé de revêtement d'un substrat (1), dans lequel un liquide contenant du matériau de revêtement est pulvérisé à l'aide d'un champ électrique, le liquide contenant le matériau de revêtement sortant d'une électrode (6) sous forme de spray et étant chargé électriquement par ladite électrode, et une structure (2) électriquement conductrice du substrat étant amenée à un potentiel électrique de sorte que le liquide (5) pulvérisé est attiré,
dans lequel il y a une ou plusieurs structures adjacentes (4, 7) supplémentaires pour régler la géométrie de surface du matériau déposé (3), qui sont amenées à un potentiel pendant l'étape de revêtement, à savoir à un tel potentiel, qui repousse le liquide pulvérisé (5), une masque (4) étant utilisée comme structure adjacente, **caractérisé en ce que** la gamme de tension de la masque par rapport au substrat est comprise entre -50V et - 100V.

2. Procédé selon la revendication 1, **caractérisé en ce qu'**un ou plusieurs potentiel(s) d'une ou de plusieurs structures adjacentes (4, 7) sont réglés et/ou changés de sorte qu'une ou plusieurs couches à surface plane sont simultanément déposées sur une ou plusieurs structures (2) polarisées de manière attirante du substrat (1).

3. Procédé selon l'une des revendications précédentes, dans lequel une structure polarisée de manière attirante (2) du substrat (1) est simultanément revêtue sur toute sa surface.

4. Procédé selon l'une des revendications précédentes, dans lequel la masque (4) comprend une pluralité d'ouvertures et derrière chaque ouverture se trouve une structure (2), qui est polarisée de manière attirante pendant l'étape de revêtement.

5. Procédé selon l'une des revendications précédentes, dans lequel le substrat (1) comprend une pluralité de structures (2) électriquement conductrices, qui sont électriquement séparées l'une de l'autre, et dans lequel seulement une partie des structures (2) électriquement conductrices est polarisée de manière attirante pendant l'opération de revêtement, de sorte que le liquide (5) pulvérisé est dirigé dans la direction de ces structures (2) électriquement conductrices et l'autre partie des structures (2) électriquement conductrices est polarisée de manière repoussante pendant l'opération de revêtement,

6. Procédé selon l'une des revendications précédentes, dans lequel plusieurs couches (3) ayant des épaisseurs de couche différentes sont générées en amenant des structures conductrices (2) se trouvant sur le substrat (1) à un potentiel attirant pendant des périodes de durée variable pendant une étape de revêtement.

7. Procédé selon l'une des revendications précédentes, dans lequel, à la suite de l'opération de revêtement, on fabrique un écran, une diode électroluminescente ou une cellule photovoltaïque à partir de l'élément de construction.
